# EUROPEAN PATENT APPLICATION

(11) **EP 4 657 156 A2**
(43) Date of publication of application: **03.12.2025**
(21) Application number: 25176628.3
(22) Date of filing: 15.05.2025
(51) Int. Cl.: G03F 1/00

(54) **PHOTOMASK BLANK**

(30) Priority: 30.05.2024 JP 2024087719
(71) Applicant: SHIN-ETSU CHEMICAL CO., LTD.,, Chiyoda-ku, Tokyo 1000005 (JP)
(72) Inventor: SAKURAI, Keisuke, Joetsu-shi, 9428601 (JP); MIYAJIMA, Chiaki, Joetsu-shi, 9428601 (JP); KANEKO, Hideo, Joetsu-shi, 9428601 (JP)
(74) Representative: Mewburn Ellis LLP

(57) **Abstract**

A photomask blank including a light-shielding film that has high light-shielding property and high resistance to SPM cleaning is provided by a light-shielding film including a protection layer that is provided at the side remotest from the transparent substrate and composed of a material containing silicon and being free of a transition metal, and a light-shielding layer that is provided at the transparent substrate-side of the protection layer and composed of a material containing a transition metal and silicon.

## Description

### TECHNICAL FIELD

The present invention relates to a photomask blank that serves as a material for a photomask used in microfabrication of semiconductor integrated circuits, CCDs (Charge-Coupled Devices), color filters for LCDs (Liquid Crystal Display devices), magnetic heads, and others, particularly, to a photomask blank that serves as a material for a photomask suitable for ArF excimer laser exposure.

### BACKGROUND

In the recent semiconductor processing technology, particularly, a challenge to higher integration of large-scale integrated circuits places a demand for miniaturization of circuit patterns. There is a demand for further reduction in size of circuit-constructing wiring patterns and for miniaturization of contact hole patterns for cell-constructing interlayer connections. As a consequence, in the manufacture of circuit pattern-written photomasks for use in the photolithography of forming such wiring patterns and contact hole patterns, a technique capable of accurately writing finer circuit patterns is needed.

In order to form a higher accuracy photomask pattern on a photomask substrate, it is of first priority to form a high accuracy resist pattern on a photomask blank. In actual process of semiconductor substrates, optical lithography is performed by reduced projection. Thus, the photomask pattern has a size of about four time of the actually required pattern size. However, this does not mean that lower accuracy is acceptable, instead, higher accuracy is required.

Further, in the currently prevailing lithography, a circuit pattern to be written already has a size far smaller than the wavelength of light used. If a photomask pattern which is a mere four-time magnification of the circuit shape is used, a shape corresponding to the photomask pattern is not transferred to the resist film due to influences such as optical interference occurring in the actual photolithography operation. In order to mitigate these influences, in some cases, the photomask pattern must be designed to a shape which is more complex than the actual circuit pattern, i.e., a shape to which the so-called optical proximity correction (OPC) is applied. Therefore, at the present, the lithography technology for obtaining photomask patterns also requires a higher accuracy processing method.

In forming a pattern of a light-shielding film from a photomask blank, usually, a resist film is formed on a photomask blank including the light-shielding film on a transparent substrate, a pattern is drawn by electron beam and developed to obtain a resist pattern. Then, the obtained resist pattern is used as an etching mask, and the light-shielding film is processed by etching to form a light-shielding pattern. However, in the case that the light-shielding pattern is miniaturized, if a finer photomask pattern is processed while maintaining the thickness of the resist film at the same thickness as before miniaturizing the light-shielding pattern, a ratio of the film thickness to a pattern width, so-called an aspect ratio, results in a high ratio. Consequently, the shape of the resist pattern deteriorates, and the pattern transfer results in failure, and in some cases, the resist pattern may collapse or peel off. Therefore, it is necessary to thin the resist film in accordance with the miniaturization of the pattern.

Many light-shielding films for photomask blanks have been proposed. Most of them relate to knowledge of etching, and as a material for the light-shielding film, chromium compounds having an established a standard processing method in practical use has been used for the film. As a light-shielding film composed of a chromium compound, for example, JP-A-2003-195479 (Patent Document 1) describes a light-shielding film composed of a chromium compound having a thickness of 50 to 77 nm, as a light-shielding film in a photomask blank used for ArF excimer laser exposure.

However, dry etching using chlorine-based gas containing oxygen, which is a general dry etching condition for a chromium-based film such as a chromium compound film, also etches the resist film on some level. When the etching is performed with a thinner resist film to transfer a finer pattern, it has been difficult to transfer the resist pattern accurately since the resist film is damaged during the etching. Therefore, in order to achieve miniaturization of pattern and high accuracy simultaneously, reconsideration for materials that improve processability of the light-shielding film has been needed instead of consideration depending on only improvement of resist performance.

For example, JP-A 2007-241060 (Patent Document 2) discloses that, to obtain further higher accurate processability with using a light-shielding film constituted with a material containing a transition metal and silicon, an etching mask film composed of a chromium-based material is provided on the light-shielding film.

### Citation List

Patent Document 1: JP-A 2003-195479
Patent Document 2: JP-A 2007-241060
Patent Document 3: JP-A 2006-78807

### SUMMARY OF THE INVENTION

In a manufacturing process of a mask blank and a lithography process, cleaning using a sulfuric acid-hydrogen peroxide mixture (SPM) cleaning is usually performed to clean the surfaces of a photomask blank or a photomask. However, in a material containing a transition metal such as molybdenum, which is a material for a light-shielding film of the photomask blank, there is a problem that deterioration of the film and reduction in the thickness of the film are caused by repeating the SPM cleaning, resulting in deterioration of light-shielding property.

The present invention has been made to solve the above problem, and an object of the present invention is to provide, as a photomask blank including a light-shielding film composed of a material containing a transition metal such as molybdenum, and silicon, a photomask blank in which light-shielding property of the light-shielding film is hard to deteriorate even when SPM cleaning is repeated.

With respect to a light-shielding film composed of a material containing a transition metal such as molybdenum, and silicon in a photomask blank, the inventors have made earnestly studies to solve the above problem. As a result, the inventors found a light-shielding film including a protection layer that is provided at the side remotest from the transparent substrate and composed of a material containing silicon and being free of a transition metal, and a light-shielding layer that is provided at the transparent substrate-side of the protection layer and composed of a material containing a transition metal and silicon, and found that the light-shielding film has high light-shielding property and high resistance to SPM cleaning, simultaneously.

In one aspect, the invention provides a photomask blank including a transparent substrate, and a light-shielding film formed on the transparent substrate wherein
the light-shielding film is composed of a material containing a transition metal and silicon,
the light-shielding film has a thickness of not less than 30 nm and not more than 80 nm,
the light-shielding film is constituted of multiple layers including a protection layer that is provided at the side remotest from the transparent substrate and composed of a material containing silicon and being free of a transition metal, and one or two or more light-shielding layers that are provided at the transparent substrate-side of the protection layer and composed of a material containing a transition metal and silicon,
the protection layer has a thickness of not less than 1 nm and less than 8 nm, and
the light-shielding layer has a transition metal content of not less than 1 at%.

Preferably, the material containing a transition metal and silicon that forms the light-shielding film further contains at least one selected from the group consisting of oxygen, nitrogen and carbon.

Preferably, the material containing silicon and being free of a transition metal that forms the protection layer further contains either or both of oxygen and nitrogen.

Preferably, the transition metal that is contained in the material that forms the light-shielding film and the light-shielding layer is molybdenum.

Preferably, both the protection layer and the light-shielding layer are composed of a material that can be etched by dry etching using a fluorine-based gas.

Preferably, when the light-shielding film is contacted with an SPM cleaning solution that is a mixture of 96 wt% sulfuric acid and 30 wt% hydrogen peroxide solution at a volume ratio of sulfuric acid/hydrogen peroxide solution=3/1 at 120 °C for 18 minutes, a ratio of variation of an optical density (OD) of the light-shielding film at a wavelength of exposure light after the light-shielding film is contacted with the SPM cleaning solution relative to an optical density (OD) of the light-shielding film at the wavelength of the exposure light before the light-shielding film is contacted with the SPM cleaning solution is less than 2%.

Preferably, the photomask blank is a binary photomask blank.

Preferably, the photomask blank further includes a hard mask film at the side remote from the transparent substrate of the light-shielding film.

### ADVANTAGEOUS EFFECTS

The light-shielding film of the photomask blank of the invention has high resistance to SPM cleaning, thus, the light-shielding property of the light-shielding film is hard to deteriorate even when the SPM cleaning is repeated.

### BRIEF DESCRIPTION OF THE DRAWINGS

FIG. 1 is a cross-sectional view illustrating an example of first embodiment of a photomask blank of the invention.
FIG. 2 is a cross-sectional view illustrating an example of second embodiment of a photomask blank of the invention.

### FURTHER EXPLANATIONS; OPTIONS AND PREFERENCES

A photomask blank of the invention includes a transparent substrate, and a light-shielding film that is formed on the transparent substrate. From the photomask blank of the invention, a photomask including a circuit pattern (photomask pattern) can be manufactured. The photomask blank of the invention includes a binary photomask blank, and a phase shift photomask blank such as a halftone phase shift photomask blank.

Generally, a photomask in which a circuit pattern (photomask pattern) consists of a portion (light-shielding portion) that is formed of a light-shielding film and substantially shields exposure light completely, and a portion (transparent portion) that does not shield the exposure light, and light-shielding property of the circuit pattern consists of binary of light-shielding and non-light-shielding is called the binary photomask. A material for manufacturing the binary photomask is called a binary photomask blank. From the binary photomask blank, a binary photomask including a circuit pattern (photomask pattern) of the light-shielding film can be manufactured.

On the other hand, when the photomask blank of the invention is a phase shift photomask blank such as a halftone phase shift photomask blank, a phase shift film such as a halftone phase shift film may be provided between the transparent substrate and the light-shielding film. A phase shift photomask blank such as a halftone phase shift photomask blank is a material for a phase shift photomask such as a halftone phase shift photomask. From the phase shift photomask blank, a phase shift photomask having a circuit pattern (photomask pattern) of the phase shift film can be manufactured.

Further, when the photomask blank of the invention is a phase shift photomask blank, a phase shift photomask in which a circuit pattern (photomask pattern) is formed in the transparent substrate by engraving the pattern into the transparent substrate can be manufactured.

A target exposure light (light used in exposure using a photomask) of the photomask blank and photomask of the invention is preferably, for example, light having a wavelength of not more than 250 nm, particular, light having a wavelength of not more than 200 nm, such as ArF excimer laser (wavelength: 193 nm), however, not particularly limited thereto.

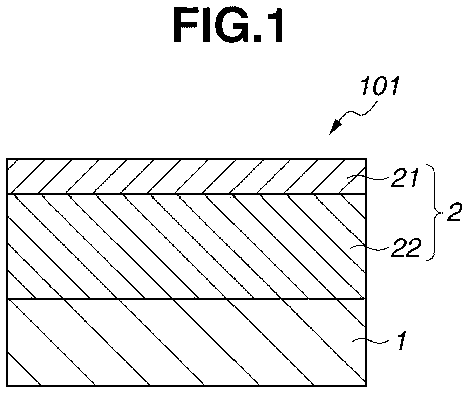

FIG. 1 is a cross-sectional view illustrating an example of first embodiment of a photomask blank of the invention. This photomask blank 101 includes, on a transparent substrate 1, a light-shielding film 2 that is formed in contact with the transparent substrate 1. This photomask blank 101 is suitable for a binary photomask blank, or a phase shift photomask blank in which a circuit pattern (photomask pattern) will be formed in the transparent substrate. Further, the light-shielding film 2 is constituted of a protection layer 21 that is provided at the side remotest from the transparent substrate 1, and a light-shielding layer 22 that is provided between the transparent substrate 1 and the protection layer 21 and in contact with both.

Material or sizes of the transparent substrate are not particularly limited, and a preferable transparent substrate is a substrate transparent to exposure light that is used for a transmissive photomask blank such as a binary photomask blank and a phase shift photomask blank, and a transmissive photomask such as a binary photomask and a phase shift photomask, in particular, a quartz substrate such as a synthetic quartz substrate. A suitable transparent substrate is a substrate called a 6025 substrate having sizes of 6 inches square and a thickness of 0.25 inches, which is defined in the SEMI standard. The 6025 substrate is generally represented as a substrate having sizes of 152 mm square and 6.35 mm thick in the SI unit system.

The light-shielding film is formed directly or via another film on the transparent substrate. In the case that the photomask blank is a phase shift photomask blank such as a halftone phase shift photomask blank, a phase shift film such as a halftone phase shift film may be formed, as the other film, between the transparent substrate and the light-shielding film. In this case, an etching stopper film is preferably formed, as the other film, between the light-shielding film and the phase shift film.

The light-shielding film is composed of a material containing a transition metal and silicon. Preferably, the material containing a transition metal and silicon that forms the light-shielding film further contains at least one light element selected from the group consisting of oxygen, nitrogen and carbon. Particularly, the material that forms the light-shielding film is preferably a material containing a transition metal, silicon and either or both of oxygen and nitrogen. The material containing a transition metal, silicon and either or both of oxygen and nitrogen may further contain carbon.

Preferable transition metals that form the light-shielding film include transition metals excluding chromium. In particular, examples of the transition metals include molybdenum, tungsten, tantalum, titanium, zirconium, hafnium and others, and molybdenum is most preferable in the viewpoint of productivity by dry etching.

The light-shielding film is preferably composed of a material that can be etched by dry etching using a fluorine-based gas (fluorine-based dry etching). Further, the light-shielding film is preferably composed of a material that is resistant to dry etching using a chlorine-based gas containing oxygen (chlorine-oxygen gas) (chlorine-based dry etching).

The light-shielding film has a thickness (a total thickness of the light-shielding film) of preferably not less than 20 nm, more preferably not less than 30 nm, even more preferably not less than 40 nm in the viewpoint of ensuring light-shielding property to exposure light, and preferably not more than 90 nm, more preferably not more than 80 nm, even more preferably not more than 70 nm in the viewpoint of responding to requirement for pattern miniaturization.

Particularly, in the case that the photomask blank is a binary photomask blank or a phase shift photomask blank in which a circuit pattern (photomask pattern) will be formed in the transparent substrate, the light-shielding film has a thickness (a total thickness of the light-shielding film) of preferably not less than 30 nm, more preferably not less than 40 nm, and preferably not more than 90 nm, more preferably not more than 80 nm. In this case, the light-shielding film has an optical density (OD) of preferably not less than 2.5, more preferably not less than 2.8, with respect to exposure light, particularly, with respect to the wavelength (193 nm) of ArF excimer laser. On the other hand, the light-shielding film normally has an upper limit of the optical density (OD) of not more than 5, however, not particularly limited thereto.

Further, in the case that the photomask blank is a phase shift photomask blank including a phase shift film such as a halftone phase shift film, the light-shielding film has a thickness (a total thickness of the light-shielding film) of preferably not less than 20 nm, more preferably not less than 30 nm, and preferably not more than 80 nm, more preferably not more than 70 nm. In this case, the light-shielding film has an optical density (OD) preferably of not less than 1, more preferably not less than 1.5, and preferably not more than 4.5, more preferably not more than 4, with respect to exposure light, particularly, with respect to the wavelength (193 nm) of ArF excimer laser. Furthermore, the light-shielding film and the film(s) provided between the transparent substrate and the light-shielding film (the phase shift film, the etching stopper film and others) have a total optical density (OD) of preferably not less than 2.5, more preferably not less than 2.8, with respect to exposure light, particularly, with respect to the wavelength (193 nm) of ArF excimer laser. On the other hand, the light-shielding film and the other film(s) normally have an upper limit of the total optical density (OD) of not more than 5, however, not particularly limited thereto.

The light-shielding film is constituted of multiple layers (for example, two to ten layers, preferably, two layers, three layers or four layers). As a layer constituting the multiple layers, the light-shielding film includes a protection layer that is provided at the side remotest from the transparent substrate. On the other hand, as a layer constituting the multiple layers, the light-shielding includes a light-shielding layer that is provided, as a layer other than the protection layer, at the transparent substrate-side of the protection layer, and at least the layer closest to the transparent substrate is preferably the light-shielding layer. The layers constituting the multiple layers may include a layer other than the protection layer and the light-shielding layer, however, preferably consist of the protection layer and the light-shielding layer only.

Each layer constituting the multiple layers of the light-shielding film may be individually a single-composition layer having a constant composition in the thickness direction, or a composition-graded layer having a composition that varies continuously in the thickness direction. The light-shielding film may be formed of only the single-composition layers, only the composition-graded layers, or a combination of the single-composition layer and the composition-graded layer.

In the multiple layers of the light-shielding film, it is preferable that the optical density (OD) at the side remote from the transparent substrate is low in the viewpoint of reducing reflectance with respect to exposure light. Particularly, in the whole layer(s) excluding the protection layer, preferably the whole layers including the protection layer, or in the composition-graded layer, it is preferable that a content of a light element, particularly either or both of oxygen and nitrogen at the side remote from the transparent substrate is high. In this case, the optical density (OD) at the transparent substrate-side may be high. In the whole layer(s) excluding the protection layer, preferably the whole layers including the protection layer, or in the composition-graded layer, the optical density (OD) may be high, in particular, a content of a light element, particularly either or both of oxygen and nitrogen may be low, at the portion excluding the side remote from the transparent substrate. In particular, a light-shielding film that is constituted of three layers of, from the side remote from the transparent substrate, a protection layer, a light-shielding layer having a low optical density (OD), and a light-shielding layer having a high optical density (OD) is exemplified as such a light-shielding film.

Further, in the multiple layers of the light-shielding film, it is preferable that the optical density (OD) at the transparent substrate-side is also low in the viewpoint of reducing reflectance with respect to exposure light. Particularly, in the whole layer(s) excluding the protection layer, or in the composition-graded layer, it is preferable that a content of a light element, particularly either or both of oxygen and nitrogen at the transparent substrate-side is high. In this case, the optical density (OD) may be high, in particular, a content of either or both of oxygen and nitrogen may be low, at the portion excluding both of the side remote from the transparent substrate and the transparent substrate-side (the optical density (OD) may be high, in particular, a content of either or both of oxygen and nitrogen may be low, at the central potion in the thickness direction of the light-shielding film). In particular, a light-shielding film that is constituted of four layers of, from the side remote from the transparent substrate, a protection layer, a light-shielding layer having a low optical density (OD), a light-shielding layer having a high optical density (OD), and a light-shielding layer having a low optical density (OD) is exemplified as such a light-shielding film.

The protection layer is composed of a material containing silicon and being free of a transition metal. However, the protection layer accepts containing a transition metal as an impurity. The protection layer not containing a transition metal is hard to be deteriorated by SPM cleaning, thus, high resistance of the light-shielding film to the SPM cleaning can be obtained by providing the protection layer at the side remotest from the transparent substrate. The protection layer may be constructed with two or more (for example, two to five) sublayers. Each sublayer may be a single-composition layer or a composition-graded layer.

Preferably, the material containing silicon and being free of a transition metal that forms the protection layer further contains at least one light element selected from the group consisting of oxygen, nitrogen and carbon. The material that forms the protection layer more preferably contains either or both of oxygen and nitrogen, and a material contains silicon and oxygen is particular preferable.

In particular, examples of the materials that form the protection layer include a material consisting of only silicon (Si), a material consisting of silicon and oxygen (SiO), a material consisting of silicon and nitrogen (SiN) and a material consisting of silicon, oxygen and nitrogen (SiON). Among them, a material consisting of silicon and oxygen (SiO), a material consisting of silicon and nitrogen (SiN) or a material consisting of silicon, oxygen and nitrogen (SiON) is preferable, and a material consisting of silicon, oxygen and nitrogen (SiON) is more preferable.

The material that forms the protection layer may be a material consisting of only silicon (Si) in the viewpoint of resistance to SPM cleaning. However, since the protection layer is a layer disposed at the side remotest from the transparent substrate in the light-shielding film, and a layer in which exposure light is incident, a material containing, as a light element, either or both of oxygen and nitrogen, particularly oxygen, especially a material consisting of silicon and oxygen (SiO) is effective to reduce reflectance of the light-shielding film with respect to exposure light.

The material that forms the protection layer has a silicon content of preferably not less than 30 at%, and preferably not more than 99 at%, more preferably not more than 60 at%, even more preferably not more than 50 at%.

When the material that forms the protection layer contains oxygen, the protection layer has an oxygen content of preferably not less than 1 at%, more preferably not less than 40 at%, even more preferably not less than 50 at%, and preferably not more than 70 at%. When the material that forms the protection layer contains nitrogen, the protection layer has a nitrogen content of preferably not less than 1 at%, more preferably not less than 20 at%, even more preferably not less than 40 at%, and preferably not more than 60 at%. Further, when the material that forms the protection layer contains both oxygen and nitrogen, the protection layer has a total content of oxygen and nitrogen of preferably not less than 1 at%, more preferably not less than 40 at%, even more preferably not less than 50 at%, and preferably not more than 70 at%.

The protection layer is preferably composed of a material that can be etched by dry etching using a fluorine-based gas (fluorine-based dry etching). Further, the protection layer is preferably composed of a material that is resistant to dry etching using a chlorine-based gas containing oxygen (chlorine-oxygen gas) (chlorine-based dry etching).

The protection layer is preferably thin in consideration for shortening etching time to form a pattern of the light-shielding film and for obtaining a good cross-sectional shape of the pattern. The protection layer has a thickness (a total thickness of all sublayers in the case of the protection layer constructed with two or more sublayers) of preferably less than 8 nm, more preferably not more than 5 nm, even more preferably not more than 3 nm. On the other hand, when the thickness of the protection layer is too thin, sufficient SPM cleaning resistance cannot be obtained, and it may be difficult to control the thickness when the protection layer is formed. Thus, the protection layer has a thickness of preferably not less than 1 nm. Further, the protection layer has an optical density (OD) of preferably not more than 1, more preferably not more than 0.5, even more preferably not more than 0.05, with respect to exposure light, particularly, with respect to the wavelength (193 nm) of ArF excimer laser.

The light-shielding layer is composed of a material containing a transition metal and silicon. Preferably, the material containing a transition metal and silicon that forms the light-shielding layer further contains at least one light element selected from the group consisting of oxygen, nitrogen and carbon. The material that forms the light-shielding layer more preferably contains a transition metal, silicon and nitrogen. In this case, the material containing a transition metal, silicon and nitrogen may further contain either or both of oxygen and carbon.

Preferable transition metals that form the light-shielding layer include transition metals excluding chromium. In particular, examples of the transition metals include molybdenum, tungsten, tantalum, titanium, zirconium, hafnium and others, and molybdenum is most preferable in the viewpoint of productivity by dry etching.

In particular, examples of the materials that form the light-shielding layer include a material consisting of molybdenum, silicon and nitrogen (MoSiN), a material consisting of molybdenum, silicon, oxygen and nitrogen (MoSiON), a material consisting of molybdenum, silicon, nitrogen and carbon (MoSiNC), and a material consisting of molybdenum, silicon, oxygen, nitrogen and carbon (MoSiONC).

The material that forms the light-shielding layer has a transition metal content of preferably not less than 1 at%, more preferably not less than 5 at%, even more preferably not less than 10 at%, and preferably not more than 40 at%, more preferably not more than 30 at%. On the other hand, the material that forms the light-shielding layer has a silicon content of preferably not less than 30 at%, more preferably not less than 40 at%, even more preferably not less than 50 at%, and preferably not more than 90 at%, more preferably not more than 80 at%.

When the material that forms the light-shielding layer contains nitrogen, the light-shielding layer has a nitrogen content of preferably not less than 3 at%, more preferably not less than 5 at%, and preferably not more than 50 at%, more preferably not more than 40 at%. When the material that forms the light-shielding layer contains oxygen, the light-shielding layer has an oxygen content of preferably not less than 0.5 at%, more preferably not less than 1 at%, and preferably not more than 50 at%, more preferably not more than 30 at%. When the material that forms the light-shielding layer contains carbon, the light-shielding layer has a carbon content of preferably not less than 0.2 at%, more preferably not less than 0.4 at%, and preferably not more than 10 at%, more preferably not more than 5 at%. Further, when the material that forms the light-shielding layer contains at least one light element selected from the group consisting of oxygen, nitrogen and carbon, the light-shielding layer has a total content of the light element of preferably not less than 0.5 at%, more preferably not less than 5 at%, and preferably not more than 60 at%, more preferably not more than 50 at%.

The light-shielding layer is preferably composed of a material that can be etched by dry etching using a fluorine-based gas (fluorine-based dry etching). Further, the light-shielding layer is preferably composed of a material that is resistant to dry etching using a chlorine-based gas containing oxygen (chlorine-oxygen gas) (chlorine-based dry etching).

The light-shielding layer has a thickness (a total thickness of all light-shielding layers in the case of the light-shielding layer constructed with two or more layers) that corresponds to a thickness excluding the thickness of the protection layer from the thickness of the whole of the light-shielding film in the case that the light-shielding film does not include another layer other than the protection layer and the light-shielding layer. In the case that the light-shielding film includes another layer other than the protection layer and the light-shielding layer, the thickness of the light-shielding layer (total thickness of the light-shielding layers) is preferably not less than 60%, more preferably not less than 90%, even more preferably 100%, of the total thickness of the layers other than the protection layer in the viewpoint of ensuring sufficient light-shielding property. Further, the layer(s) excluding the protection layer in the light-shielding film has an optical density (OD) with respect to exposure light that corresponds to an optical density (OD) excluding the optical density (OD) of the protection layer from the optical density (OD) of the light-shielding film.

The light-shielding film (each layer such as the protection layer and the light-shielding layer constituting the light-shielding film, and each sublayer constituting the protection layer) is preferably formed by a sputtering method that can be easy to form a film (layer or sublayer) having good homogeneity, and either DC sputtering or RF sputtering can be applied. A target and a sputter gas are appropriately selected depending on the composition of the material that forms the light-shielding film.

The target may be used by appropriately selecting the target from the group consisting of a target consisting of a transition metal such as a transition metal target (for example, a molybdenum target), a target consisting of a transition metal and silicon such as a transition metal silicon target (for example, a molybdenum silicide target), a silicon target (a target consisting of silicon), and a target consisting of silicon and nitrogen such as a silicon nitride target and a target containing both silicon and silicon nitride.

As the sputtering gas, a rare gas (inert gas) such as helium gas, neon gas and argon gas can be used, and argon gas is preferable as the rare gas. Further, in the case of forming with a material containing a light element such as oxygen, nitrogen and carbon, the sputtering may be reactive sputtering using a reactive gas with the rare gas. The content of the light element can be adjusted by appropriately setting an amount of the reactive gas.

As the reactive gas, for example, oxygen gas (O₂ gas) can be used in the case of forming with a material containing oxygen, nitrogen gas (N₂ gas) can be used in the case of forming with a material containing nitrogen, nitrogen oxide gas such as nitrogen monoxide gas (NO gas), nitrogen dioxide gas (NO₂ gas) and nitrous oxide gas (N₂O gas) can be used in the case of forming with a material containing oxygen and nitrogen, and carbon oxide gas such as carbon monoxide gas (CO gas) and carbon dioxide gas (CO₂ gas) can be used in the case of forming with a material containing carbon and oxygen.

The sputtering is performed under a sputtering pressure of preferably not less than 0.01 Pa, more preferably not less than 0.03 Pa, and preferably not more than 10 Pa, more preferably not more than 0.1 Pa.

The light-shielding film of the invention has high resistance to SPM cleaning. In particular, as an SPM cleaning solution for use in the SPM cleaning, an SPM cleaning solution that is a mixture of 96 wt% sulfuric acid (aqueous solution) and 30 wt% hydrogen peroxide solution (aqueous solution) at a volume ratio of sulfuric acid (aqueous solution)/hydrogen peroxide solution (aqueous solution)=3/1 is exemplified.

When the light-shielding film of the invention is contacted with an SPM cleaning solution that is a mixture of 96 wt% sulfuric acid (aqueous solution) and 30 wt% hydrogen peroxide solution (aqueous solution) at a volume ratio of sulfuric acid (aqueous solution)/hydrogen peroxide solution (aqueous solution)=3/1 at 120 °C for 18 minutes, a ratio of variation of an optical density (OD) of the light-shielding film at a wavelength of exposure light after the light-shielding film is contacted with the SPM cleaning solution relative to an optical density (OD) of the light-shielding film at the wavelength of the exposure light before the light-shielding film is contacted with the SPM cleaning solution is, for example, less than 2%, particularly not more than 1%. The light-shielding film of the invention has advanced resistance to the SPM cleaning.

The phase shift film is a film that has a function for increasing contrast by interference of exposure light at the boundary portion between an area where the phase shift film is present (a phase shift portion) and an area where the phase shift film is not present due to phase shift between the phases of the exposure light that have passed through the respective areas. The phase shift film may be constructed with a single layer or multiple layers.

The phase shift film has a phase shift with respect to exposure light, i.e., a phase shift between the exposure light that has passed through the phase shift film, and the exposure light that has passed through an air layer having the same thickness as the phase shift film, of preferably not less than 150°, more preferably not less than 160°, even more preferably not less than 175°, and preferably not more than 200°, more preferably not more than 190°, even more preferably not more than 185°.

Preferably, the phase shift film is a halftone phase shift film. The halftone phase shift film has a transmittance with respect to exposure light of preferably not less than 5%, and preferably not more than 30%, however, not particularly limited thereto.

The phase shift film is preferably composed of a material that can be etched by dry etching using a fluorine-based gas (fluorine-based dry etching). Further, the phase shift film is preferably composed of a material that is resistant to dry etching using a chlorine-based gas containing oxygen (chlorine-oxygen gas) (chlorine-based dry etching).

As such a material, a silicon compound containing silicon, and at least one selected from the group consisting of oxygen and nitrogen, and a transition metal silicon compound containing a transition metal, silicon, and at least one selected from the group consisting of oxygen, nitrogen and carbon are exemplified.

As the transition metal of the material that forms the phase shift film, transition metals excluding chromium are preferable. In particular, examples of the transition metals include molybdenum, tungsten, tantalum, titanium, zirconium, hafnium and others, and molybdenum is most preferable in the viewpoint of productivity by dry etching.

In the case that the material that forms the phase shift film is the silicon compound, the silicon compound has a silicon content of preferably not less than 30 at%, more preferably not less than 40 at%, and preferably not more than 80 at%, more preferably not more than 60 at%, an oxygen content of preferably not more than 60 at%, more preferably not more than 20 at%, and a nitrogen content of preferably not less than 10 at%, more preferably not less than 30 at%, and preferably not more than 65 at%, more preferably not more than 60 at%.

On the other hand, in the case the material that forms the phase shift film is the transition metal silicon compound, the transition metal silicon compound has a transition metal content of preferably not less than 0.1 at%, more preferably not less than 1 at%, and preferably not more than 30 at%, more preferably not more than 20 at%, a silicon content of preferably not less than 25 at%, more preferably not less than 30 at%, and preferably not more than 80 at%, more preferably not more than 60 at%, an oxygen content of preferably not less than 5 at%, and preferably not more than 70 at%, more preferably not more than 20 at%, a nitrogen content of preferably not less than 10 at%, more preferably not less than 25 at%, and preferably not more than 60 at%, more preferably not more than 57 at%, and a carbon content of preferably not more than 10 at%, more preferably not more than 5 at%.

The phase shift film has a thickness of preferably not more than 100 nm, more preferably not more than 80 nm, even more preferably not more than 70 nm. On the other hand, the thickness of the phase shift film is set within a range providing necessary optical properties with respect to exposure light, particularly, with respect to the wavelength (193 nm) of ArF excimer laser, and the phase shift film has a lower limit of the thickness of normally not less than 50 nm, however, not particularly limited thereto.

The phase shift film (each layer constituting the phase shift film) is preferably formed by a sputtering method that can be easy to form a film (layer) having good homogeneity, and either DC sputtering or RF sputtering can be applied. A target and a sputter gas are appropriately selected depending on the composition of the material that forms the phase shift film.

The target may be used by appropriately selecting the target from the group consisting of a target consisting of a transition metal such as a transition metal target (for example, a molybdenum target), a target consisting of a transition metal and silicon such as a transition metal silicon target (for example, a molybdenum silicide target), a silicon target (a target consisting of silicon), and a target consisting of silicon and nitrogen such as a silicon nitride target and a target containing both silicon and silicon nitride.

As the sputtering gas, a rare gas (inert gas) such as helium gas, neon gas and argon gas can be used, and argon gas is preferable as the rare gas. Further, in the case of forming with a material containing a light element such as oxygen, nitrogen and carbon, the sputtering may be reactive sputtering using a reactive gas with the rare gas. The content of the light element can be adjusted by appropriately setting an amount of the reactive gas. As the reactive gas, the same gases exemplified in the formation of the light-shielding film can be used.

The sputtering is performed under a sputtering pressure of preferably not less than 0.01 Pa, more preferably not less than 0.03 Pa, and preferably not more than 10 Pa, more preferably not more than 0.1 Pa.

The etching stopper film is a film that functions as an etching stopper in etching of the light-shielding film. The etching stopper film may be constructed with a single layer or multiple layers. The etching stopper film is preferably composed of a material that is resistant to dry etching using a fluorine-based gas (fluorine-based dry etching). Further, the etching stopper film is preferably composed of a material that can be etched by dry etching using a chlorine-based gas containing oxygen (chlorine-oxygen gas) (chlorine-based dry etching).

As such a material, a material containing chromium is preferable. As the material containing chromium, simple chromium, and a chromium compound containing chromium, and at least one selected from the group consisting of oxygen, nitrogen and carbon, in particular, a chromium oxide (CrO), a chromium nitride (CrN), a chromium carbide (CrC), a chromium oxide nitride (CrON), a chromium oxide carbide (CrOC), a chromium nitride carbide (CrNC), and a chromium oxide nitride carbide (CrONC) are exemplified.

In the case that the material containing chromium is the chromium compound, the chromium compound has a chromium content of preferably not less than 30 at%, more preferably not less than 35 at%, and less than 100 at%, preferably not more than 90 at%, an oxygen content of preferably not more than 60 at%, more preferably not more than 50 at%, a nitrogen content of preferably not more than 50 at%, more preferably not more than 40 at%, and a carbon content of preferably not more than 30 at%, more preferably not more than 20 at%. Further, the chromium compound has a total content of chromium, oxygen, nitrogen and carbon of preferably not less than 95 at%, more preferably not less than 99 at%, even more preferably 100 at%. The etching stopper film has a thickness of preferably not less than 1 nm, more preferably not less than 3 nm, and preferably not more than 20 nm, more preferably not more than 10 nm.

The etching stopper film (each layer constituting the etching stopper film) is preferably formed by a sputtering method that can be easy to form a film (layer) having good homogeneity, and either DC sputtering or RF sputtering can be applied. A target and a sputter gas are appropriately selected depending on the composition of the material that forms the etching stopper film.

The target may be used by appropriately selecting the target from the group consisting of a target consisting of chromium such as a chromium target, and a target of chromium added with at least one selected from the group consisting of oxygen, nitrogen and carbon.

As the sputtering gas, a rare gas (inert gas) such as helium gas, neon gas and argon gas can be used, and argon gas is preferable as the rare gas. Further, in the case of forming with a material containing a light element such as oxygen, nitrogen and carbon, the sputtering may be reactive sputtering using a reactive gas with the rare gas. The content of the light element can be adjusted by appropriately setting an amount of the reactive gas. As the reactive gas, the same gases exemplified in the formation of the light-shielding film can be used.

The sputtering is performed under a sputtering pressure of preferably not less than 0.01 Pa, more preferably not less than 0.03 Pa, and preferably not more than 10 Pa, more preferably not more than 0.1 Pa.

The photomask blank of the invention may further include a hard mask film at the side remote from the transparent substrate of the light-shielding film, preferably in contact with the light-shielding film. The hard mask film is a film that functions as an etching aid film for the light-shielding film, and contributes to improving rough and fine dependency (reducing loading effect). By forming a hard mask film on the light-shielding film, a resist film used for forming a pattern of the light-shielding film can be thinned, and the hard mask film allows to form a finer pattern more accurately. The hard mask film may be constructed with a single layer or multiple layers.

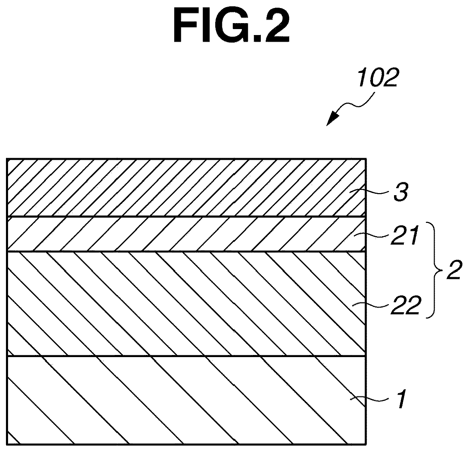

FIG. 2 is a cross-sectional view illustrating an example of second embodiment of a photomask blank of the invention. This photomask blank 102 includes, on a transparent substrate 1, a light-shielding film 2 that is formed in contact with the transparent substrate 1, and a hard mask film 3 that is formed in contact with the light-shielding film 2. This photomask blank 102 is suitable for a binary photomask blank, or a phase shift photomask blank in which a circuit pattern (photomask pattern) will be formed in the transparent substrate. Further, the light-shielding film 2 is constituted of a protection layer 21 that is provided at the side remotest from the transparent substrate 1, and a light-shielding layer 22 that is provided between the transparent substrate 1 and the protection layer 21 and in contact with both.

The hard mask film is preferably composed of a material having etching characteristics different from those of the light-shielding film, particularly the protection layer. The hard mask film is preferably composed of a material that is resistant to dry etching using a fluorine-based gas (fluorine-based dry etching), which is suitably applied to etching for the light-shielding film, particularly the protection layer. Further, the hard mask film is preferably composed of a material that can be etched by dry etching using a chlorine-based gas containing oxygen (chlorine-oxygen gas) (chlorine-based dry etching).

The hard mask film is preferably composed of a material containing chromium. The material containing chromium may further contain at least one light element selected from the group consisting of oxygen, nitrogen and carbon.

As the material containing chromium, in particular, simple chromium (Cr), and a chromium compound such as a material consisting of chromium and oxygen (CrO), a material consisting of chromium and nitrogen (CrN), a material consisting of chromium, oxygen and nitrogen (CrON), a material consisting of chromium and carbon (CrC), a material consisting of chromium, oxygen and carbon (CrOC), a material consisting of chromium, nitrogen and carbon (CrNC), and a material consisting of chromium, oxygen, nitrogen and carbon (CrONC) are exemplified.

In the case that the material that forms the hard mask film is the chromium compound, the chromium compound has a chromium content of preferably not less than 30 at%, more preferably not less than 35 at%, and less than 100 at%, preferably not more than 99 at%, more preferably not more than 90 at%, an oxygen content of preferably not more than 60 at%, more preferably not more than 40 at%, and preferably not less than 1 at%, a nitrogen content of preferably not more than 50 at%, more preferably not more than 40 at%, and preferably not less than 1 at%, and a carbon content of preferably not more than 30 at%, more preferably not more than 20 at%, and preferably not less than 1 at%. In the case that the material that forms the hard mask film contains chromium, and at least one light element selected from the group consisting of oxygen, nitrogen and carbon, the material has a total content of chromium and the light element of preferably not less than 95 at%, more preferably not less than 99 at%, even more preferably 100 at%.

The hard mask film has a thickness of preferably not less than 1 nm, more preferably not less than 2 nm, and preferably not more than 30 nm, more preferably not more than 20 nm.

The hard mask film (each layer constituting the hard mask film) is preferably formed by a sputtering method that can be easy to form a film (layer) having good homogeneity, and either DC sputtering or RF sputtering can be applied. A target and a sputter gas are appropriately selected depending on the composition of the material that forms the hard mask film.

The target may be used by appropriately selecting the target from the group consisting of a target consisting of chromium such as a chromium target, and a target of chromium added with at least one selected from the group consisting of oxygen, nitrogen and carbon.

As the sputtering gas, a rare gas (inert gas) such as helium gas, neon gas and argon gas can be used, and argon gas is preferable as the rare gas. Further, in the case of forming with a material containing a light element such as oxygen, nitrogen and carbon, the sputtering may be reactive sputtering using a reactive gas with the rare gas. The content of the light element can be adjusted by appropriately setting an amount of the reactive gas. As the reactive gas, the same gases exemplified in the formation of the light-shielding film can be used.

The sputtering is performed under a sputtering pressure of preferably not less than 0.01 Pa, more preferably not less than 0.03 Pa, and preferably not more than 10 Pa, more preferably not more than 0.1 Pa.

### EXAMPLE

Examples are given below for further illustrating the invention although the invention is not limited thereto.

### Examples 1 to 5

A light-shielding layer (thickness: 56 nm) composed of a material consisting of molybdenum, silicon, oxygen and nitrogen (MoSiON; molybdenum: 11 at%, silicon: 42 at%, oxygen: 5 at%, nitrogen: 42 at%), and having an optical density (OD) of 3 was formed on a transparent substrate made of quartz that has dimensions of 152 mm-square and about 6 mm-thick by sputtering using a molybdenum target and a silicon target, as sputtering targets, and argon gas (Ar gas), oxygen gas (O₂ gas) and nitrogen gas (N₂ gas), as sputtering gases.

Next, a protection layer (thickness: 2 nm) composed of a material consisting of silicon and oxygen (SiO), a material consisting of silicon and nitrogen (SiN), or a material consisting of silicon, oxygen and nitrogen (SiON) was formed on the light-shielding layer by sputtering using a silicon target, as a target, and argon gas (Ar gas), and either or both of oxygen gas (O₂ gas) and nitrogen gas (N₂ gas) appropriately selected depending on the composition, as sputtering gases, to obtain a photomask blank. After forming the protection layer, the optical density (OD) increased not more than 0.05 in each. The composition of the protection layer is shown in Table 1.

### Comparative Example 1

A photomask blank including a light-shielding film consisting of only the light-shielding layer was obtained by forming the light-shielding layer in the same manner as in Example 1 without forming the protection layer.

Next, resistance to SPM cleaning of the light-shielding films of each of the photomask blanks obtained in Examples 1 to 5 and Comparative Example 1 was evaluated. By using a mixture of 96 wt% sulfuric acid (aqueous solution) and 30 wt% hydrogen peroxide solution (aqueous solution) at a volume ratio of sulfuric acid (aqueous solution)/hydrogen peroxide solution (aqueous solution)=3/1, a cycle (treatment from contact to dry) of contacting the surface of the light-shielding film of the photomask blank with the SPM cleaning solution at 120 °C for 6 minutes, rinsing the SPM cleaning solution with pure water for 1 minute, and drying the light-shielding film for 4 minutes was performed for three cycles. A ratio of variation of an optical density (OD) of the light-shielding film with respect to ArF excimer laser (wavelength: 193 nm) between before and after the treatment for three cycles was evaluated. The ratio of variation of the optical density is shown in Table 1.

**Table 1**

| | Layer remotest from substrate | Composition | Content [at%] | | | | Ratio of variation in optical density [%] |
|---|---|---|---|---|---|---|---|
| | | | Si | O | N | Mo | |
| Example 1 | Protection layer | SiO | 34 | 66 | 0 | 0 | 0 |
| Example 2 | Protection layer | SiO | 55 | 45 | 0 | 0 | 0 |
| Example 3 | Protection layer | SiN | 47 | 0 | 53 | 0 | 0 |
| Example 4 | Protection layer | SiN | 76 | 0 | 24 | 0 | 0 |
| Example 5 | Protection layer | SiON | 38 | 40 | 22 | 0 | 0 |
| Comparative Example 1 | Light-shielding layer | MoSiON | 42 | 5 | 42 | 11 | 2 |

## Claims

1. A photomask blank comprising a transparent substrate, and a light-shielding film formed on the transparent substrate wherein
the light-shielding film is composed of a material comprising a transition metal and silicon,
the light-shielding film has a thickness of not less than 30 nm and not more than 80 nm,
the light-shielding film is constituted of multiple layers comprising a protection layer that is provided at the side remotest from the transparent substrate and composed of a material comprising silicon and being free of a transition metal, and one or two or more light-shielding layers that are provided at the transparent substrate-side of the protection layer and composed of a material comprising a transition metal and silicon,
the protection layer has a thickness of not less than 1 nm and less than 8 nm, and the light-shielding layer has a transition metal content of not less than 1 at%.

2. The photomask blank of claim 1 wherein the material comprising a transition metal and silicon that forms the light-shielding film further comprises at least one selected from the group consisting of oxygen, nitrogen and carbon.

3. The photomask blank of claim 1 or 2 wherein the material comprising silicon and being free of a transition metal that forms the protection layer further comprises either or both of oxygen and nitrogen.

4. The photomask blank of any one of claims 1 to 3 wherein the transition metal that is comprised in the material that forms the light-shielding film and the light-shielding layer is molybdenum.

5. The photomask blank of any one of claims 1 to 4 wherein both the protection layer and the light-shielding layer are composed of a material that can be etched by dry etching using a fluorine-based gas.

6. The photomask blank of any one of claims 1 to 5 wherein when the light-shielding film is contacted with an SPM cleaning solution that is a mixture of 96 wt% sulfuric acid and 30 wt% hydrogen peroxide solution at a volume ratio of sulfuric acid/hydrogen peroxide solution=3/1 at 120 °C for 18 minutes, a ratio of variation of an optical density (OD) of the light-shielding film at a wavelength of exposure light after the light-shielding film is contacted with the SPM cleaning solution relative to an optical density (OD) of the light-shielding film at the wavelength of the exposure light before the light-shielding film is contacted with the SPM cleaning solution is less than 2%.

7. The photomask blank of any one of claims 1 to 6 being a binary photomask blank.

8. The photomask blank of any one of claims 1 to 7 further comprising a hard mask film at the side remote from the transparent substrate of the light-shielding film.
